# DEMANDE DE BREVET EUROPEEN

(11) **EP 1 152 246 A1**
(43) Date de publication de la demande: **07.11.2001**
(21) Numéro de dépôt: 01400855.1
(22) Date de dépôt: 03.04.2001
(51) Int. Cl.: G01R 23/15, G01R 23/10, G06K 19/07

(54) **Circuit de détection de signaux électriques à une fréquence déterminée**

(30) Priorité: 20.04.2000 FR 0005105
(71) Demandeur: STMicroelectronics SA, 94250 Gentilly (FR)
(72) Inventeur: Bardouillet, Michel, 75116 Paris (FR); Kari, Ahmed, 75116 Paris (FR)
(74) Mandataire: Ballot, Paul

(57) **Abrégé**

L'invention concerne un circuit de détection de la fréquence de signaux binaires qui comprend :
- un circuit de détection (30) des fronts montants des signaux binaires,
- un circuit de mesure (32) de la durée entre les fronts montants qui fournit un état logique (W),
- un registre à décalage (36) dont la bascule d'entrée mémorise l'état logique (W),
- un circuit de décalage des états logiques du registre à décalage (36), et
- un circuit de décodage (38) des états logiques du registre (36) qui fournit un signal de validation des signaux (BPSK).

L'invention est applicable aux lecteurs de cartes à puce sans contact.

## Description

L'invention concerne les circuits pour détecter des signaux électriques ayant une fréquence déterminée.

De tels circuits sont connus et peuvent être réalisés sous forme analogique ou sous forme numérique.

Dans un dispositif analogique, on utilise un filtre qui est centré sur la fréquence recherchée et le signal filtré est appliqué à un circuit de seuil ou détecteur de niveau. Un tel dispositif analogique est difficilement réalisable sous la forme d'un circuit intégré à un coût raisonnable.

Dans un dispositif numérique, on met en oeuvre deux procédés différents dont les premières étapes consistent à échantillonner le signal et à coder les amplitudes des échantillons. Ensuite, dans l'un des procédés, on effectue une décomposition en une série de Fourier pour déterminer si la fréquence du premier harmonique correspond à la fréquence recherchée.

Dans l'autre procédé numérique, les codes des échantillons sont appliqués à un filtre numérique centré sur la fréquence recherchée.

De tels dispositifs numériques nécessitent l'utilisation de signaux pour l'échantillonnage et le codage qui ont des fréquences très élevées par rapport à la fréquence recherchée, ce qui conduit à un circuit intégré fonctionnant à des fréquences élevées dont le coût de fabrication est également élevé.

Cet aspect du coût est d'autant plus important que ces dispositifs analogiques ou numériques sont mis en oeuvre dans des lecteurs de cartes à circuit intégré sans contact, plus connues sous l'expression de "cartes à puce sans contact", pour détecter les signaux émis par la carte à puce sans contact.

En effet, il est de plus en plus courant d'utiliser des cartes à puce sans contact, notamment pour le contrôle d'accès à certains lieux ou locaux, qui sont détectées et lues à distance par des lecteurs émettant des signaux à fréquence radio, par exemple à la fréquence Fo = 13,56 MHz. Ces signaux à la fréquence porteuse Fo sont modulés en amplitude par les chiffres binaires du message à transmettre à la carte, par exemple à une fréquence d'environ Fm = 106 KHz, soit 1/128è de la fréquence Fo.

Les signaux détectés par la carte par l'intermédiaire d'une antenne sont utilisés pour fournir l'énergie d'alimentation des circuits électroniques de la carte en ce qui concerne les signaux à la fréquence porteuse, ce qui permet ensuite de détecter les signaux de modulation et de les interpréter.

En réponse à ces signaux à modulation d'amplitude en provenance du lecteur, la carte élabore des signaux binaires qui modulent la charge d'antenne de la carte de sorte que le lecteur, qui continue à émettre à la fréquence porteuse Fo, détecte cette modulation.

Dans les cartes à puce sans contact fonctionnant à la fréquence porteuse 13,56 MHz, la fréquence de modulation du signal de la carte est de Fc = 847 KHz environ, c'est-à-dire un seizième de la fréquence porteuse.

L'information binaire est transmise par changement ou saut de phase selon une clé connue sous l'acronyme anglo-saxon "BPSK" pour "Binary Phase Shift Key". Plus précisément, le signal à la fréquence Fc change de phase de 180° lors d'un changement de chiffre binaire, de 1 vers 0 ou de 0 vers 1.

L'invention concerne plus particulièrement, dans un lecteur de carte à puce sans contact, un circuit pour détecter la présence du signal du type BPSK à la fréquence Fc = 847 KHz qui est émis par la carte à puce, ce signal étant appelé "sous-porteuse" par rapport au signal à la fréquence Fo qui est appelé "porteuse".

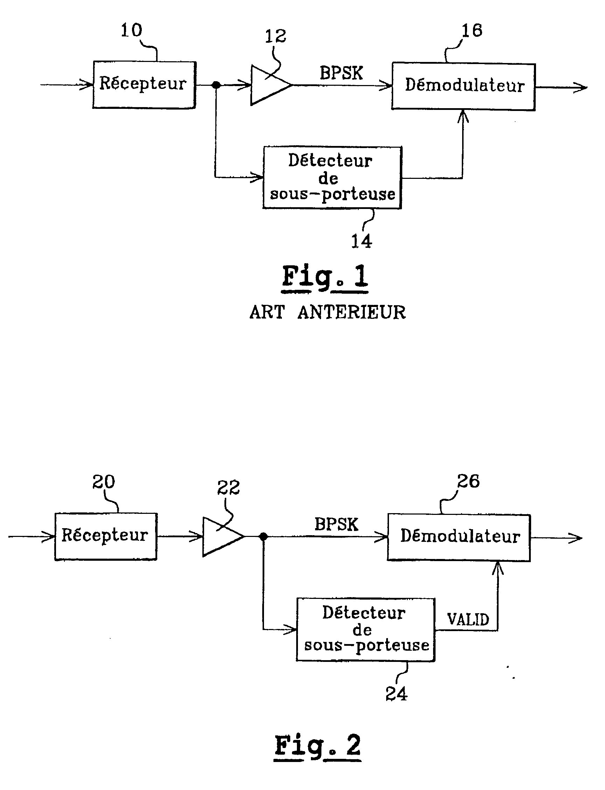

Dans un lecteur de carte à puce de l'art antérieur, selon le schéma de la figure 1, le récepteur 10 détecte le signal provenant de la carte à puce et fournit le signal détecté à un amplificateur 12 et à un détecteur de sous-porteuse 14. Le signal amplifié est appliqué à un démodulateur 16 qui est prévu pour interpréter un signal codé du type BPSK et fournir les chiffres binaires de l'information envoyée par la carte à puce. Les chiffres binaires ainsi détectés ne sont "validés" qui si le détecteur de sous-porteuse 14 fournit un signal dit de "validation" indiquant qu'il a reconnu la fréquence de la sous-porteuse et, en conséquence, que l'information binaire résultant de la démodulation peut être prise en compte.

Comme indiqué ci-dessus, le détecteur de sous-porteuse 14 réalise cette détection, soit par un filtrage analogique passe-bande suivi d'une détection de niveau, soit par une conversion analogique/numérique suivie d'un filtrage numérique ou d'une décomposition en série de Fourier dont on ne conserve que le premier harmonique.

Un but de la présente invention est donc de réaliser un circuit de détection de la présence d'un signal du type BPSK à une fréquence déterminée sans mettre en oeuvre un filtrage analogique ou numérique, une conversion analogique/numérique ou une décomposition en série de Fourier.

Un autre but de la présente invention est de réaliser un circuit de détection de la présence d'un signal du type BPSK à une fréquence déterminée en mettant en oeuvre des circuits logiques facilement réalisables en circuit intégré.

L'invention concerne donc un circuit de détection de signaux électriques à une fréquence déterminée Fc, lesdits signaux électriques étant des signaux binaires, caractérisé en ce qu'il comprend :
- un circuit de détection des fronts montants dans les signaux binaires qui fournit une impulsion CLEAR à chaque front montant,
- un circuit de mesure de la durée entre deux impulsions CLEAR qui indique par un état logique W que la durée est comprise entre une durée minimale Li et une durée maximale Ls,
- un registre à décalage dont la bascule d'entrée mémorise l'état logique W indiqué par le circuit de mesure,
- un circuit de décalage des états logiques du registre à décalage qui fournit un signal de décalage D, et
- un circuit de décodage des états logiques du registre à décalage qui fournit un signal VALID indiquant que les signaux binaires ont la fréquence requise ou non.

Le circuit de mesure comprend, de préférence :
- un compteur qui compte les impulsions d'un signal d'horloge CLK, et
- un circuit de décodage des valeurs de comptage qui fournit le signal d'état logique W lorsque lesdites valeurs de comptage sont comprises entre les durées minimale Li et maximale Ls entre deux impulsions consécutives du signal CLEAR.

Le circuit de décalage comprend, de préférence :
- un compteur qui compte les impulsions du signal d'horloge CLK, et
- un circuit de décodage d'une valeur de comptage particulière Lc qui est inférieure à la durée minimale Li.

L'invention sera mieux comprise à la lecture de la description suivante d'un exemple particulier de réalisation, ladite description étant faite en relation avec les dessins joints dans lesquels :
- la figure 1 est un schéma d'une partie de lecteur de carte à puce sans contact de l'art antérieur qui réalise la fonction de démodulation du signal du type BPSK en utilisant un détecteur du signal BPSK selon l'art antérieur,
- la figure 2 est un schéma analogue à celui de la figure 1 mais dans lequel la détection du signal BPSK est réalisée selon la présente invention,
- la figure 3 est un schéma fonctionnel d'un circuit de détection de la fréquence d'un signal BPSK selon la présente invention,
- les figures 4a, 4b et 4c sont des diagrammes de signaux, et
- la figure 5 est un schéma détaillant certains éléments du schéma de la figure 3.

La figure 1 a déjà été décrite dans le préambule.

Le schéma de la figure 2 est analogue à celui de la figure 1 en ce qu'il utilise un récepteur 20, un amplificateur à seuil 22 et un démodulateur BPSK 26 correspondant respectivement aux éléments 10, 12 et 16 de la figure 1.

Il en diffère en ce qu'il utilise un circuit de détection de la fréquence d'un signal BPSK 24 présentant des caractéristiques de la présente invention et en ce que ce circuit de détection reçoit, non pas le signal de sortie du récepteur 20, mais le signal de sortie de l'amplificateur à seuil 22. Il en résulte que les signaux appliqués au démodulateur 26 et au circuit de détection de sous-porteuse 24 sont identiques.

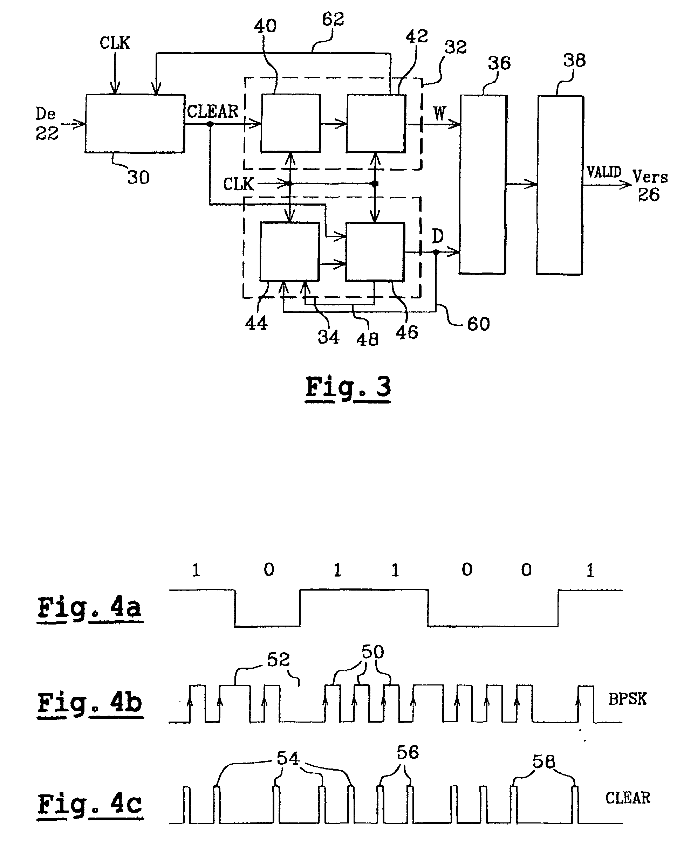

Le diagramme de la figure 4a illustre une suite de signaux binaires 1, 0, 1, 1, 0, 0, 1 tandis que le diagramme de la figure 4b illustre le signal BPSK correspondant à cette suite de signaux binaires. Ce signal consiste en un signal à une fréquence de 847 KHz par exemple, la sous-porteuse d'un système de communication entre une carte à puce sans contact et un lecteur d'une telle carte. Ce signal BPSK change de phase de 180° chaque fois que le chiffre binaire change. Ce signal présente des impulsions 50 à la fréquence 847 KHz et des impulsions 52 à la fréquence moitié, soit 423,5 KHz.

Le dispositif de détection de la fréquence d'un signal BPSK comprend, selon le schéma de la figure 3 :
- un circuit de détection des fronts montants 30 qui fournit une impulsion à chaque front montant du signal BPSK (signal CLEAR),
- un circuit de mesure 32 de la durée entre deux impulsions du signal CLEAR qui indique par un état logique W que la durée mesurée est comprise ou non entre une durée minimale Li et une durée maximale Ls,
- un registre à décalage 36 dont la bascule d'entrée mémorise l'état logique W indiqué par le circuit de mesure 32,
- un circuit de commande de décalage 34 des états logiques du registre à décalage 36 qui fournit un signal de décalage D, et
- un circuit de décodage 38 des états logiques du registre à décalage 34 qui fournit un signal de validation VALID indiquant que le signal BPSK d'entrée a la fréquence requise ou non.

Les différents éléments 30, 32 et 34 reçoivent un signal d'horloge CLK dont la fréquence est, dans le cas d'un lecteur de cartes à puce, égale, par exemple à Fo = 13,56 MHz.

Le circuit de mesure 32 comprend un circuit de comptage 40 qui compte les impulsions du signal d'horloge CLK et un circuit de décodage 42 de valeurs de comptage du compteur 40 correspondant aux durées Li et Ls ainsi qu'à une valeur de dépassement "DEP".

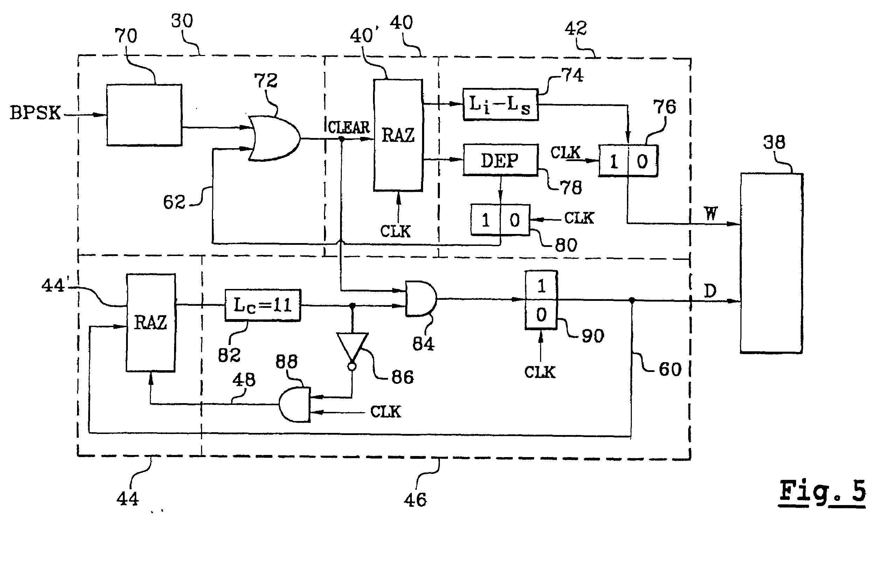

Plus précisément (figure 5), le circuit de comptage 40 comprend un compteur 40' présentant une borne d'entrée de remise à zéro RAZ sur laquelle sont appliquées les impulsions du signal CLEAR et une borne d'entrée du signal d'horloge CLK. Certaines des bornes de sortie du compteur 40' sont connectées à un décodeur 74 qui détecte les valeurs de comptage comprises entre les durées Li et Ls. D'autres bornes de sortie sont connectées à un décodeur 78 qui détecte une valeur de dépassement DEP de comptage.

La borne de sortie du décodeur 74 est connectée à une borne d'entrée de commande d'une bascule 76 dont une autre borne d'entrée reçoit le signal d'horloge CLK.

Le signal W est fourni par une borne de sortie de la bascule 76.

La borne de sortie du décodeur 78 est connectée à une borne d'entrée de commande d'une bascule 80 dont une autre borne d'entrée reçoit le signal d'horloge CLK.

Le signal fourni par une borne de sortie de la bascule 80 est appliqué par un conducteur 62 à une borne d'entrée d'un circuit logique OU référencé 72.

L'autre borne d'entrée du circuit logique 72 reçoit les impulsions représentatives des fronts montants du signal BPSK, fronts montants détectés par un circuit 70. En d'autres termes, les impulsions du signal CLEAR sont composées d'impulsions 54 représentatives (Figure 4c) des fronts montants du signal BPSK et des impulsions représentatives d'une valeur DEP de comptage du compteur 40'.

Le circuit de commande de décalage 34 comprend un compteur 44 qui compte les impulsions du signal d'horloge CLK et un circuit de décodage 46 d'une certaine valeur Lc du compteur correspondant au signal de décalage D.

Plus précisément (figure 5), le compteur 44 ou 44' présente une borne d'entrée de remise à zéro RAZ sur laquelle est appliqué le signal de décalage D par l'intermédiaire d'un conducteur 60 et une borne d'entrée du signal d'horloge CLK.

Certaines des bornes de sortie du compteur 44 ou 44' sont connectées à un décodeur 82 qui détecte la valeur de comptage "Lc" prise égale à "ONZE" comme expliqué ci-après. La borne de sortie du décodeur 82 est connectée directement à une borne d'entrée d'un premier circuit logique ET référencé 84 et par l'intermédiaire d'un circuit inverseur 86 à une borne d'entrée d'un deuxième circuit logique ET référencé 88.

La deuxième borne d'entrée du circuit logique 84 est connectée à la borne de sortie du circuit logique 72 et reçoit donc le signal CLEAR. La borne de sortie du circuit logique 84 est connectée à une borne d'entrée de commande d'une bascule 90 dont une autre borne d'entrée reçoit le signal d'horloge CLK. Une borne de sortie de la bascule 90 fournit le signal de décalage D qui est appliqué au registre à décalage 38 et à la borne d'entrée RAZ du compteur 44 ou 44'.

Le deuxième circuit logique 88 a une deuxième borne d'entrée qui reçoit le signal d'horloge CLK et une borne de sortie qui est connectée à la borne d'entrée du signal d'horloge CLK par un conducteur 48.

Le dispositif selon les schémas des figures 3 et 5 réalise la détection d'un signal à la fréquence 847 KHz en mesurant les durées des signaux fournis par l'amplificateur 22 (Figure 2). Si leur durée est comprise entre les durées Li et Ls (signal W), un état logique 1 est enregistré dans le registre à décalage 36.

Si leur durée est en dehors de ces limites, un état logique 0 est enregistré dans le registre à décalage 36.

Ces états logiques 1 ou 0 sont enregistrés et décalés à chaque apparition du signal de décalage D.

Lorsque le nombre d'états logiques 1 contenus dans le registre à décalage est supérieur à une certaine valeur, il est considéré que le signal fourni par l'amplificateur 22 et donc du récepteur 20 est à la fréquence 847 KHz.

Selon l'invention, le signal BPSK (Figure 4b) est appliqué au circuit 30 qui détecte les fronts avant (avec flèche vers le haut) et fournit des impulsions 54 constituant le signal CLEAR. Ce sont les durées entre les impulsions 54 qui sont mesurées par le compteur 40, 40', en comptant le nombre d'impulsions d'horloge CLK dont la fréquence est seize fois plus grande que celle du signal BPSK (rapport 13,56 MHz/847 KHz). Les valeurs Li, Ls, Lc et DEP sont donc exprimées en nombre d'impulsions du signal d'horloge CLK.

En théorie, la durée entre deux impulsions consécutives 56 (sans changement de phase) est de seize impulsions d'horloge CLK et elle est de vingt-quatre impulsions d'horloge CLK entre deux impulsions consécutives 58 (avec changement de phase), soit Ls = 23.

Cependant, en pratique, les impulsions 54, 56 et 58 ne sont pas stables et il faut en tenir compte en considérant que la durée minimale peut être inférieure à seize, par exemple égale à douze, soit Li = 12.

Les impulsions du signal CLEAR remettent à l'état zéro le compteur 40 de sorte que le nombre affiché par le compteur est une mesure de la durée écoulée à compter de l'instant d'apparition de l'impulsion du signal CLEAR.

Lorsque le compteur 44 atteint la valeur (Lc = 11), cette valeur est détectée par le circuit de décodage 82 qui fournit le signal de décalage D du registre à décalage 38 lors de l'apparition de l'impulsion CLEAR suivante, via les circuits 84 et 90, impulsion qui détermine la fin de l'intervalle de temps à mesurer.

Par ailleurs, le décodage de cette valeur (Lc = 11) permet de bloquer le comptage du compteur 44 par un signal sur le conducteur 48 via les circuits 86 et 88 et le compteur 44 reste à cette valeur.

L'impulsion d'horloge suivante CLK fait passer le compteur 40 dans la position "DOUZE" (Li = 12). Cette valeur est détectée par le circuit de décodage 74 qui fournit un signal W, dit de créneau ou fenêtre, de passage à l'état 1 de la première bascule du registre à décalage 36. Cet état 1 sera décalé vers la bascule suivante lors de l'apparition du signal de décalage D due à l'impulsion CLEAR qui détermine la fin de l'intervalle de temps à mesurer.

Il en résulte que les compteurs 40 et 44 sont remis à zéro à chaque apparition d'une impulsion du signal CLEAR de sorte que les deux compteurs fonctionnent normalement en synchronisme.

L'état 1 du signal W demeure tant que le compteur 40 est entre 12 (Li = 12) et 23 (Ls = 23) en l'absence de l'impulsion CLEAR suivante. Dès l'arrivée de cette dernière, le compteur 40 est remis à l'état 0, de sorte que le signal W revient à l'état 0 tandis que le signal D effectue le décalage de l'état 1 dans le registre à décalage 36 et remet à l'état 0 le compteur 44 par un conducteur 60.

Si le compteur 40 atteint la position "24" (DEP = 24) avant l'apparition de l'impulsion CLEAR suivante, le signal de décodage de cette position (décodeur 78) remet à zéro le compteur 40 par l'intermédiaire d'un signal sur un conducteur 62 via le circuit 80.

Si ce fonctionnement normal s'établit, les bascules, par exemple au nombre de huit, du registre à décalage 36 passeront toutes à l'état 1, ce qui signifie que le signal BPSK est à la fréquence requise soit 847 KHz. L'état 1 de toutes les bascules est détecté par un circuit de décodage 38 qui fournit un signal de validation VALID appliqué au démodulateur 26 (figure 2).

Par suite des instabilités affectant les signaux reçus par le lecteur, l'obtention et le maintien d'un état logique 1 dans toutes les bascules du registre 36 ne sont pas un but réaliste. Aussi, l'invention prévoit que le signal VALID apparaisse lorsqu'un certain nombre des huit bascules, par exemple 5, sont à l'état 1.

Dans le cas où la fréquence de la sous-porteuse du signal BPSK est supérieure à 847 KHz, l'impulsion du signal CLEAR apparaîtra avant que le compteur 40 n'ait atteint la valeur "DOUZE" de sorte que le signal W restera à l'état 0, état 0 qui est transmis à la première bascule du registre à décalage 36 et qui est décalé vers la bascule suivante par le signal de décalage D apparaissant lors de l'impulsion suivante du signal CLEAR.

Après un certain temps, le nombre d'états 1 dans le registre à décalage 36 devient inférieur à cinq et le signal VALID disparaît, ce qui interdit de prendre en compte la sortie du démodulateur 26.

Dans le cas d'absence de sous-porteuse, le compteur 40 compte jusqu'à la valeur "24" car l'impulsion suivante du signal CLEAR n'apparaît pas (absence de sous-porteuse). Le circuit de décodage 78 détecte cette valeur "24" et fournit un signal de dépassement qui remet à zéro le compteur 40 par le conducteur 62. Par ailleurs, le signal W, qui était passé à l'état 1 entre les valeurs 12 à 23, revient à l'état 0 et cet état est appliqué à la première bascule du registre à décalage 36.

De manière similaire, le compteur 44 a compté jusqu'à la valeur 11 et reste bloqué à cette valeur.

Le signal de décalage D n'apparaît que lorsque le signal de dépassement (DEP = 24) est détecté via les circuits 78, 80, 72, 84 et 90, et a pour effet de décaler l'état 0 du signal W de la première bascule vers la deuxième bascule du registre à décalage 36 et de remettre à zéro le compteur 44, 44'.

Après un certain temps, le nombre d'états 1 dans le registre à décalage 36 devient inférieur à cinq et le signal VALID disparaît, ce qui interdit de prendre en compte la sortie du démodulateur 26.

Dans le cas où la fréquence de la sous-porteuse est très inférieure à 847 KHz et a une valeur telle que le compteur 40 atteint la valeur "24" avant l'apparition de l'impulsion suivante du signal CLEAR, alors le fonctionnement est similaire à celui en cas d'absence de sous-porteuse décrit ci-dessus.

Cependant, par suite de la présence d'impulsions dans le signal CLEAR, correspondant à des fronts montants, la première impulsion de ce signal CLEAR apparaissant après la remise à zéro du compteur 40 par le signal de dépassement mettra à zéro le compteur 40 avant qu'il n'atteigne la valeur "12" de sorte que le signal W reste à l'état 0.

Tant que le compteur 44, 44' n'atteint pas la valeur "11", le signal de décalage D n'apparaîtra pas pour décaler les états des bascules et pour remettre à zéro le compteur 44. Ce compteur 44 continuera à compter à partir de la valeur atteinte alors que le compteur 40 recommence à partir de la valeur "0".

Il en résulte un décalage entre les valeurs simultanées des deux compteurs 40 et 44, le compteur 44 étant à une valeur plus élevée de sorte que la valeur "ONZE" est atteinte et autorise l'apparition du signal de décalage D plusieurs périodes du signal d'horloge CLK avant que le compteur 40 n'atteigne la valeur "12".

Dans ces conditions, si l'impulsion suivante du signal CLEAR apparaît avant que le compteur 40 n'atteigne la valeur "12", le signal W sera à l'état 0 et cet état 0 sera inscrit dans la première bascule puis décalé dans la deuxième bascule grâce au signal de décalage D, ce qui correspond à une absence de reconnaissance de la fréquence de la sous-porteuse.

Par contre, si l'impulsion suivante du signal CLEAR apparaît après que le compteur 40 a atteint la valeur "12", le signal W passera à l'état 1 qui correspond à une reconnaissance de la fréquence de la sous-porteuse. Dans le cas où la fréquence de la sous-porteuse est très supérieure à 847 Khz, le compteur 40, 40' n'atteindra jamais la valeur "12" de sorte que le signal W restera à l'état 0. Par contre, le compteur 44, 44' atteindra la valeur "11" de manière systématique, de sorte que le signal D apparaîtra lors de l'impulsion CLEAR suivante et décalera l'état 0 du signal W dans le registre 36.

Dès que le nombre d'états 0 du registre à décalage 38 est supérieur à trois, le signal VALID n'apparaît pas, ce qui signifie que la sous-porteuse n'a pas été reconnue.

L'invention a été décrite en relation avec un exemple particulier de réalisation, notamment à des signaux BPSK et à des valeurs de fréquence déterminées. Cependant, l'invention peut être mise en oeuvre pour d'autres fréquences mais aussi en utilisant des valeurs Li, Ls, Lc et DEP différentes. En outre, l'invention est applicable à des signaux autres que ceux du type BPSK.

## Revendications

1. Circuit de détection de signaux électriques à une fréquence déterminée (Fc), lesdits signaux électriques étant des signaux binaires, **caractérisé en ce qu'**il comprend :
- un circuit de détection des fronts montants (30) dans les signaux binaires qui fournit une impulsion (CLEAR) à chaque front montant,
- un circuit de mesure (32) de la durée entre deux impulsions consécutives (CLEAR) qui indique par un état logique (W) que la durée est comprise entre une durée minimale (Li) et une durée maximale (Ls),
- un registre à décalage (36) dont la bascule d'entrée mémorise l'état logique (W) indiqué par le circuit de mesure (32),
- un circuit de décalage (34) des états logiques du registre à décalage (36) qui fournit un signal de décalage (D), et
- un circuit de décodage (38) des états logiques du registre à décalage (34) qui fournit un signal VALID indiquant que les signaux binaires ont la fréquence requise ou non.

2. Circuit selon la revendication 1, **caractérisé en ce que** le circuit de mesure (32) comprend :
- un premier compteur (40) qui compte les impulsions d'un signal d'horloge (CLK) entre deux impulsions consécutives du signal (CLEAR) remettant à zéro ledit compteur (40), et
- un premier circuit de décodage (42) de certaines valeurs de comptage (Li, Ls, DEP) qui fournit le signal d'état logique (W) lorsque lesdites valeurs de comptage sont comprises entre les durées minimale (Li) et maximale (Ls) entre deux impulsions consécutives du signal (CLEAR) ainsi qu'un signal de dépassement de durée (DEP) de comptage remettant à zéro ledit compteur (40).

3. Circuit selon la revendication 1 ou 2, **caractérisé en ce que** le circuit de décalage (34) des états logiques du registre à décalage comprend :
- un deuxième compteur (44) qui compte les impulsions d'un signal d'horloge (CLK) entre deux impulsions consécutives du signal de décalage (D), et
- un deuxième circuit de décodage (46) d'une valeur de comptage particulière (Lc) inférieure à la durée minimale (Li) de manière à autoriser le signal de décalage (D) seulement si la valeur de comptage (Lc) est atteinte.

4. Circuit selon la revendication 2 ou 3, **caractérisé en ce que** le premier circuit de décodage (42) comprend :
- un premier décodeur (74) des valeurs de comptage comprises entre les durées minimale (Li) et maximale (Ls),
- une bascule (76) pour mémoriser le signal de sortie du premier décodeur (74) de manière à fournir le signal d'état logique (W),
- un deuxième décodeur (78) de la valeur de dépassement (DEP), et
- une bascule (80) pour mémoriser le signal de sortie du deuxième décodeur (78) de manière à fournir un signal de remise à zéro du premier compteur (40).

5. Circuit selon la revendication 2, 3 ou 4, **caractérisé en ce que** le deuxième circuit de décodage comprend :
- un troisième décodeur (82) de la valeur de comptage particulière (Lc),
- un premier circuit logique (86, 88) pour bloquer le comptage du deuxième compteur (44) par suite du décodage de la valeur de comptage particulière (Lc), et
- un deuxième circuit logique (84, 90) pour fournir le signal de décalage (D) par suite du décodage de la valeur de comptage particulière (Lc).
